# EUROPEAN PATENT APPLICATION

(11) **EP 1 443 569 A2**
(43) Date of publication of application: **04.08.2004**
(21) Application number: 03101347.7
(22) Date of filing: 14.05.2003
(51) Int. Cl.: H01L 39/22, H03B 15/00

(54) **Superconducting electromagnetic wave radiation device**

(30) Priority: 30.01.2003 KR 2003006280
(71) Applicant: Postech Foundation, Pohang-City, Kyungsangbuk-do (KR)
(72) Inventor: Lee, Hu Jong Pohang University of Science & Tech., Pohang-city, Kyungsangbuk-do (KR); Bae, Myung Ho Pohang University of Science & Tech., Pohang-city, Kyungsangbuk-do (KR)
(74) Representative: Stanley, David William

(57) **Abstract**

A THz electromagnetic wave radiation device uses a high-Tc superconductor. An electromagnetic wave generation unit (A) and an electromagnetic wave detection unit (B) are each formed of a superconducting single crystal mesa structure (300) wherein intrinsic Josephson junctions (6) of superconducting layers (2) and insulating layers (4) are serially stacked and can respectively excite and detect a THz electromagnetic wave. Radiation of the excited THz electromagnetic wave is coupled to the detection unit (B) through an insulating unit (C) instead of being emitted into free space (air). Shapiro steps in current-to-voltage characteristic are measured, and characteristics and frequency of THz electromagnetic waves extracted from the wave-generating unit are accurately diagnosed.

## Description

The present invention relates to THz (terahertz) electromagnetic wave radiation devices using a high-T_{c} (critical temperature) superconductor and fabrication methods therefor.

As is well known, in a highly anisotropic high-Tc superconducting singcrystal, such as Bi₂Sr₂CaCu₂O_{8+X} or Tl₂Ba₂Ca₂Cu₃O_{10+X}, intrinsic Josephson junctions are uniformly stacked at a nm-scale repetition interval. In an intrinsic Josephson junction, an approximately 1-nm-thick insulating layer is inserted between adjacent CuO₂ superconducting electrodes, through which superconducting electron pairs can tunnel. If an external magnetic field is applied in parallel with a junction plane to a stack of intrinsic Josephson junctions, whose length is longer than the Josephson penetration depth, Josephson fluxons are generated in insulating layers of intrinsic Josephson junctions. By applying a Josephson tunnelling bias current, the Josephson fluxons are driven along the junctions between stacked superconducting layers. While driven along the insulating layers at a high speed close to 1% of the speed of light by the Lorentz force of a tunnelling Josephson current of approximately 10³ ampere/cm², the Josephson fluxons excite extremely high frequency THz oscillation inside a stack relevant to subsequent plasma oscillation of superconducting electron pairs. The plasma oscillation can be converted to THz electromagnetic wave radiation at the boundary of a stack of intrinsic Josephson junctions.

There are many technical obstacles, however, in developing a THz electromagnetic wave radiation device by using a rapid motion of Josephson fluxons in intrinsic Josephson junctions. For example, the dielectric constant of an insulating layer in an intrinsic Josephson junction, ranging from 10 to 20, is much higher than the value 1 of free space (air). This impedance mismatch between the intrinsic Josephson junctions and the free space (air) makes it difficult to convert the THz plasma oscillation inside intrinsic Josephson junctions into a corresponding electromagnetic wave radiation in free space. This kind of technical obstacle makes it difficult to even confirm the generation of the THz electromagnetic wave oscillation itself inside intrinsic Josephson junctions.

Preferred embodiments of the present invention aim to provide a THz electromagnetic wave radiation and detection device which is capable of confirming fluxon-flow THz electromagnetic oscillation and accurately detecting characteristics and frequencies of the oscillation.

Another aim is to provide a method of manufacturing such a THz electromagnetic wave radiation and detection device.

According to one aspect of the present invention, there is provided a THz electromagnetic wave radiation and detection device comprising:
an electromagnetic radiation unit which is formed of a superconducting single crystal mesa structure in which intrinsic Josephson junctions of superconducting layers and insulating layers are serially stacked and which can excite a THz electromagnetic wave;
an insulating unit which contacts the electromagnetic wave generation unit and is not conductive; and
an electromagnetic wave detection unit which contacts the insulating unit, is formed of the superconducting single crystal mesa structure in which intrinsic Josephson junctions of the superconducting layers and the insulating layers are serially stacked, and can detect the THz electromagnetic wave.

Preferably, the electromagnetic wave generation unit and the insulating unit correspond to a long side of the superconducting single crystal mesa structure, which has a T shape, and the electromagnetic wave detection unit corresponds to a short side of the superconducting single crystal mesa structure having the T shape.

Preferably, the length of the long side of the superconducting single crystal mesa structure having the T shape included in the electromagnetic wave generation unit is longer than the Josephson penetration depth, and the length of the short side of the superconducting single crystal mesa structure having the T shape included in the electromagnetic wave detection unit is shorter than the Josephson penetration depth.

Thus, such an arrangement may provide that the length of the electromagnetic wave generation unit at a right angle to an external magnetic field is longer than the Josephson penetration depth, and the length of the electromagnetic detection unit at a right angle to the external magnetic field is shorter than the Josephson penetration depth.

In another aspect, the invention provides a THz electromagnetic wave radiation and detection device comprising:
a first mesa structure unit which is formed of a superconducting single crystal mesa structure wherein intrinsic Josephson junctions of superconducting layers and insulating layers are serially stacked;
an insulating unit which contacts the first mesa structure unit ; and
a second mesa structure unit which is formed of the superconducting single crystal mesa structure wherein intrinsic Josephson junctions of superconducting layers and insulating layers are serially stacked.

Preferably, the first mesa structure unit and the insulating unit correspond to a long side of the superconducting single crystal mesa structure, and the second mesa structure unit corresponds to a short side of the superconducting single crystal mesa structure.

Preferably, the length of the long side of the superconducting single crystal mesa structure, which has a T shape, included in the first mesa structure unit is longer than a Josephson penetration depth, and the length of the short side of the superconducting single crystal mesa structure having the T-shape included in the second mesa structure unit is shorter than the Josephson penetration depth.

According to a further aspect of the invention, there is provided a THz electromagnetic wave radiation and detection device comprising:
a first mesa structure unit which is formed of a superconducting single crystal mesa structure wherein intrinsic Josephson junctions of superconducting layers and insulating layers are serially stacked;
an insulating unit which contacts the first mesa structure unit and is not conductive; and
a second mesa structure unit which is formed of the superconducting single crystal mesa structure where intrinsic Josephson junctions of superconducting layers and insulating layers are serially stacked:
   wherein Josephson fluxons are formed in insulating layers of the Josephson junctions by applying an external magnetic field to the intrinsic Josephson junctions in parallel in the first mesa structure unit ; plasma radiation by the Josephson fluxon motion is maintained by flowing a tunnelling bias current along the c axis of the superconducting single crystal mesa structure included in the first mesa structure unit ; the plasma oscillation is converted into radiation of a THz electromagnetic wave while passing through the insulating unit; and the radiation frequency of the THz electromagnetic wave transmitted to the second mesa structure unit contacting the insulating unit is detected.

Preferably, the radiation of the THz electromagnetic wave transmitted to the second mesa structure unit generates current steps known as Shapiro steps at voltages corresponding to the radiation frequency f due to an inverse Josephson effect, i.e. V=hf/2e (here, h denotes the Planck constant, and e denotes the charge of electrons), and the radiation frequency of the THz electromagnetic wave is detected by using the current steps.

According to a further aspect of the invention, there is provided a THz electromagnetic wave radiation and detection device comprising:
a superconducting single crystal which is attached to a substrate and forms a superconducting single crystal mesa structure having a T shape and in which intrinsic Josephson junctions of superconducting layers and insulating layers are serially stacked;
a first gold layer which is divided into four parts on the bottom surface of the superconducting single crystal mesa structure having the T-shape;
a first voltage electrode, a first current electrode, a second voltage electrode and a second current electrode which are formed on the divided four parts of the first gold layer;
a second gold layer which is divided into four parts on the top surface of the superconducting single crystal mesa structure having the T shape;
a third voltage electrode, a third current electrode, a fourth voltage electrode and a fourth current electrode which are formed on the divided four parts of the second gold layer;
an insulating unit which is formed in the stack between the long and the short sides of the superconducting single crystal mesa structure having the T shape and in a portion where the first and second gold layers are divided; and
an insulating interlayer which is formed on a substrate so as to partially expose the first voltage electrode, the first current electrode, the second voltage electrode, the second current electrode, and fully expose the third voltage electrode, the third current electrode, the fourth voltage electrode, and the fourth current electrode:
   wherein the long side of the superconducting single crystal mesa structure having the T shape forms an electromagnetic wave generation unit where the THz electromagnetic wave is excited, and the short side of the superconducting single crystal mesa structure having the T shape forms a electromagnetic wave detection unit where the THz electromagnetic wave is diagnosed.

In another aspect, the invention provides a method of manufacturing a THz electromagnetic wave radiation and detection device, the method comprising:
fixing a superconducting single crystal mesa structure, in which intrinsic Josephson junctions of superconducting layers and insulating layers are serially stacked, to a first substrate;
forming a first gold layer on a surface of a superconducting single crystal mesa structure;
forming a superconducting mesa structure on the first substrate by patterning the first gold layer and the superconducting single crystal underneath;
dividing the first gold layer into two parts respectively for short and long sides of the superconducting single crystal mesa structure having a T shape;
forming a first voltage electrode and a first current electrode, a second voltage electrode and a second current electrode on the long and short sides of the first gold layer, respectively;
turning over the first substrate and fixing the first voltage electrode, the first current electrode, the second voltage electrode, and the second current electrode to a second substrate;
detaching the superconducting single crystal basal part along with the first substrate so as to expose the opposite side of the superconducting single crystal mesa structure;
forming an insulating interlayer on the second substrate so as to partially expose the first voltage electrode, the first current electrode, the second voltage electrode, and the second current electrode;
depositing a second gold layer on the newly exposed surface of the superconducting single crystal mesa structure;
dividing the second gold layer into two parts respectively for short and long sides of the superconducting single crystal mesa structure having the T shape;
forming a third voltage electrode and a third current electrode, a fourth voltage electrode and a fourth current electrode on the long and short sides of the second gold layer, respectively; and
forming an insulating unit in the junction area of short and long sides of the T-shaped superconducting single crystal mesa structure and in the area where the first gold layer and the second gold layer are respectively divided:
   wherein the long side of the T-shaped superconducting single crystal mesa structure constitutes an electromagnetic wave generation unit, and the short side of the T-shaped superconducting single crystal mesa structure constitutes an electromagnetic wave detection unit.

Preferably, the insulating unit is formed by performing silicon ion implantation to the stack of short and long sides of the superconducting single crystal mesa structure having the T shape and in an area where the first gold layer and the second gold layer are divided.

Preferably, fixing the superconducting single crystal mesa structure to the first substrate comprises:
spin-coating the first substrate with photoresist or polyimide in its liquid state; and
placing the superconducting single crystal on the first substrate coated with photoresist or polyimide and hard-baking the superconducting single crystal mesa structure.

Preferably, the superconducting single crystal mesa structure, the superconducting single crystal basal part, and the patterned first gold layer are formed using micropatterning and dry etching.

Preferably, a height of the superconducting single crystal mesa structure is controlled by etching time.

Preferably, in a device or method according to any of the preceding aspects of the invention, the superconducting mesa structure comprises a high-Tc superconducting single crystal. Such a high-Tc superconducting single crystal may comprise, for example, Bi₂Sr₂CaCu₂O_{8+X} or Tl₂Ba₂Ca₂Cu₃O_{10+X}.

In preferred embodiments of the present invention, a THz electromagnetic wave radiation and detection device involves the excitation of a THz electromagnetic wave in an electromagnetic wave generation unit to which an electromagnetic wave detection unit is directly connected via an insulating unit, instead of trying to extract the excited THz electromagnetic wave into free space (air). This scheme enables one to exclude the reflection loss of the excited wave at the stack boundary due to impedance mismatch. As a result, Shapiro steps in current-to-voltage characteristics are generated and measured. It is thus possible to confirm the fluxon-flow radiation of the THz electromagnetic wave and to accurately detect characteristics and frequencies of the radiation, which can be utilized as a voltage standard device unit.

For a better understanding of the invention, and to show how embodiments of the same may be carried into effect, reference will now be made, by way of example, to the accompanying diagrammatic drawings, in which:
Figure 1 is a conceptual view of one example of a THz electromagnetic wave radiation and detection device according to an embodiment of the present invention;
Figure 2 is a view of one example of a THz electromagnetic wave radiation and detection device which is manufactured according to an embodiment of the present invention; and
Figures 3 through 9 are views for explaining an example of a method of manufacturing a THz electromagnetic wave radiation and detection device according to an embodiment of the present invention.

In the figures, like references denote like or corresponding parts.

Preferred embodiments of the present invention will now be described in more detail with reference to the accompanying drawings, in which examples of embodiments of the invention are shown. This invention may, however, be embodied in many different forms and should not be construed as being limited to the examples of embodiments set forth herein. In the drawings, the forms of elements are exaggerated for clarity. It will also be understood that when a layer is referred to as being "on" another layer or substrate, it can be directly on the other layer or substrate, or intervening layers may also be present.

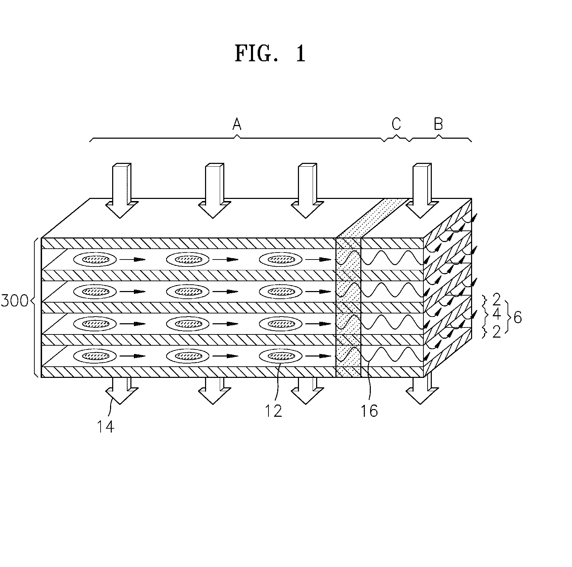

Figure 1 is a conceptual view of a THz electromagnetic wave radiation and detection device according to one example of the present invention.

More specifically, a THz electromagnetic wave radiation and detection device according to an embodiment of the present invention can be divided into three units: an electromagnetic wave generation unit A; an insulating unit C; and an electromagnetic wave detection unit B. The THz electromagnetic wave radiation and detection device is formed of a superconducting single crystal, e.g. a high-T_{c} superconducting single crystal such as Bi₂Sr₂CaCu₂O_{8+X} or Tl₂Ba₂Ca₂Cu₃O_{10+X}. The THz electromagnetic wave radiation and detection device includes a superconducting single crystal mesa structure 300 (hereinafter, referred to as a mesa structure 300).

The mesa structure 300 includes individual intrinsic Josephson junctions 6, each of which is formed of two intrinsic superconducting layers 2 and an insulating layer 4. Therefore, the THz electromagnetic wave radiation and detection device is formed of the mesa structure 300 where the intrinsic junctions 6 are serially stacked. In the electromagnetic wave radiation unit A, the superconducting single crystal is processed such that its length is longer than a Josephson penetration depth. In the electromagnetic wave detection unit B, the length of the superconducting single crystal corresponding to the horizontal length of the electromagnetic wave generation unit B, i.e. the width of the electromagnetic wave detection unit B, is shorter than the Josephson penetration depth.

If a magnetic field is applied to the electromagnetic wave generation unit A and the electromagnetic detection unit B of the mesa structure 300, Josephson fluxons 12 are generated in insulating layers 4 of the intrinsic Josephson junctions 6. If a tunnelling bias current 14 flows through the Josephson fluxons 12 along the c-axis of the superconducting single crystal, the tunnelling bias current 14 exerts a transverse Lorentz force to the Josephson fluxons 12. Thus, the Josephson fluxons 12 move at a high speed close to 1% of the speed of light along the intrinsic Josephson junctions 6, which causes a THz-range rapid time variation of the superconducting phase difference between the stacked adjacent superconducting electrodes, which induces plasma oscillation in superconducting electron pairs. The plasma oscillation is converted into a THz electromagnetic wave at the boundary between the electromagnetic wave generation unit A and the insulating unit C and is transmitted to the electromagnetic wave detection unit B.

In particular, because of the impedance mismatch between the insulating layers 4 in the mesa structure 300 and the free space (air), it is very difficult to convert a THz plasma oscillation 16 generated in the intrinsic Josephson junctions 6 into an electromagnetic wave oscillation in the free space (air). Thus, the electromagnetic wave radiation and detection device according to this embodiment of the present invention transmits the THz electromagnetic wave oscillation 16 into the detection unit B, instead of into the free space (air), through the insulating unit C with almost the same impedance as the insulting layers in both the unit A and the unit C. Figure 1 shows the procedure of driving the Josephson fluxons 12, exciting the fluxon-flow THz electromagnetic waves, coupling the excited THz electromagnetic waves to the electromagnetic wave detection unit B, and detecting characteristics of the THz radiation.

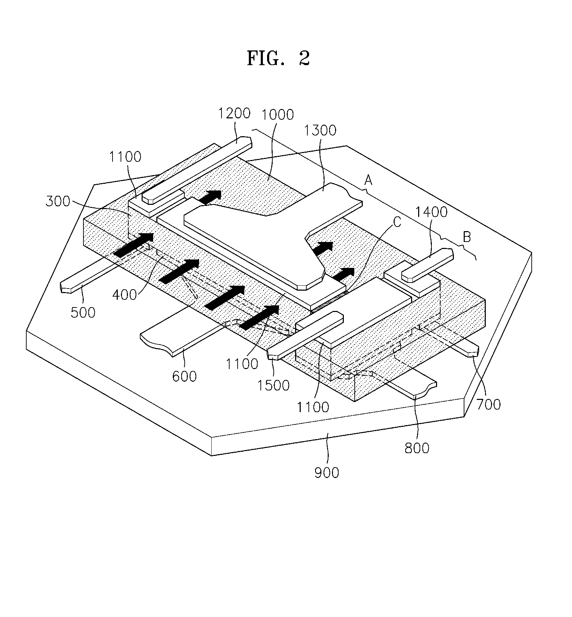

Figure 2 is the conceptual view of a THz electromagnetic wave radiation and detection device using a high-Tc superconductor which is manufactured according to an embodiment of the present invention. Reference numerals of Figure 2 that are the same as Figure 1 refer to the same elements.

More specifically, the THz electromagnetic radiation and detection device according to this embodiment of the present invention includes a superconducting single crystal mesa structure (hereinafter, referred to as a mesa structure) 300, in which intrinsic Josephson junctions 6 each having superconducting layers 2 and insulating layers 4 are serially stacked, and an electromagnetic wave generation unit A (the first mesa unit) which excites a THz electromagnetic wave. An insulating unit C, which is not conductive, contacts the electromagnetic wave generation unit A. In addition, an electromagnetic wave detection unit B (the second mesa unit), which diagnoses the THz electromagnetic wave, is included in the THz electromagnetic wave radiation and detection device according to this embodiment of the present invention.

The electromagnetic wave detection unit B, the insulating unit C, and the electromagnetic wave generation unit A are formed in the mesa structure 300 in a T shape. The electromagnetic wave generation unit A and the insulating unit C correspond to the long side of the T shape, and the electromagnetic wave detection unit B corresponds to the short side of the T shape. A superconducting single crystal forming the electromagnetic wave detection unit B and the electromagnetic wave generation unit A is a high-Tc superconductingsingle crystal such as Bi₂Sr₂CaCu₂O_{8+X} or Tl₂Ba₂Ca₂Cu₃O_{10+X}.

The length of the electromagnetic wave radiation unit A, which is at the right angle to an external magnetic field, has to be longer than the Josephson penetration depth, so that Josephson fluxons form within the electromagnetic wave generation unit A. However, the length of the electromagnetic wave detection unit B, which is at a right angle to the external magnetic field, has to be shorter than the Josephson penetration depth, so that the Josephson fluxons do not form within the electromagnetic detection unit B. That is, the length of the electromagnetic wave generation unit A at the right angle to the external electric field has to be longer than the Josephson penetration depth, and the length of the electromagnetic detection unit B at the right angle to the external magnetic field has to be shorter than the Josephson penetration depth. However, if the junction area of the electromagnetic detection unit B is too small, characteristics of an intrinsic Josephson junction of the electromagnetic wave detection unit B are lost due to the charging effect. Therefore, the junction area of the electromagnetic detection unit B should be larger than 1 µm².

A first current electrode 600 and first voltage electrode 500 are formed on a first gold layer 400 on the bottom surface of the long side of the mesa structure 300 having a T shape. A third current electrode 1300 and third voltage electrode 1200 are formed on a second gold layer 1100 on the top surface of the long side of the mesa structure 300 having the T shape. A second current electrode 800 and second voltage electrode 700 are formed on the first gold layer 400 on the bottom surface of the short side of the mesa structure 300 having the T shape. A fourth current electrode 1500 and fourth voltage electrode 1400 are formed on the second gold layer 1100 on the top surface of the short side of the mesa structure 300 having the T shape. The insulating unit C is formed in a connection portion between the long and short sides of the mesa structure 300 in the T shape and in the portion where the first gold layer 400 and the second gold layer 1100 are divided.

In particular, the THz electromagnetic wave radiation and detection device according to this embodiment of the present invention does not provides a means to convert a THz plasma oscillation excited by the motion of Josephson fluxons 12 in the electromagnetic wave generation unit A into the free space (air). Instead, the THz electromagnetic wave radiation and detection device according to this embodiment of the present invention includes the electromagnetic wave detection unit B whose length perpendicular to the external magnetic field is shorter than the Josephson penetration depth and is designed to be situated right beside the electromagnetic wave generation unit A (the first mesa structure unit). The THz plasma oscillation by the Josephson fluxons 12 excited in the electromagnetic wave generation unit A is converted into an electromagnetic wave while passing through the insulating unit C. Here, since the insulating unit C, which divides the electromagnetic wave generation unit A and the electromagnetic wave detection unit B, consists of an insulating material similar to the insulating layer 4 of the intrinsic Josephson junction 6, the fluxon-flow-induced electromagnetic wave is transmitted to the electromagnetic wave detection unit B without loss by reflection at the boundaries between the units.

The electromagnetic wave transmitted to the electromagnetic wave detection unit B through the insulating unit C induces current steps referred to as the Shapiro steps at voltages corresponding to the radiation frequency f, i.e. V = *hf*/*2e* (*h* denotes the Planck constant, *e* denotes the electric charge of an electron), due to the inverse Josephson effect. By using such current steps, it is possible to accurately diagnose the transmitted THz electromagnetic wave.

That is, according to this embodiment of the present invention, the THz electromagnetic wave excited in the electromagnetic generation unit A is sent to the electromagnetic wave detection unit B through the insulating unit C instead of being radiated to the free space (air). Then, the radiation of the electromagnetic wave is confirmed by detecting the Shapiro steps in the current-to-voltage characteristics, and thus the nature and frequencies of radiation are accurately diagnosed.

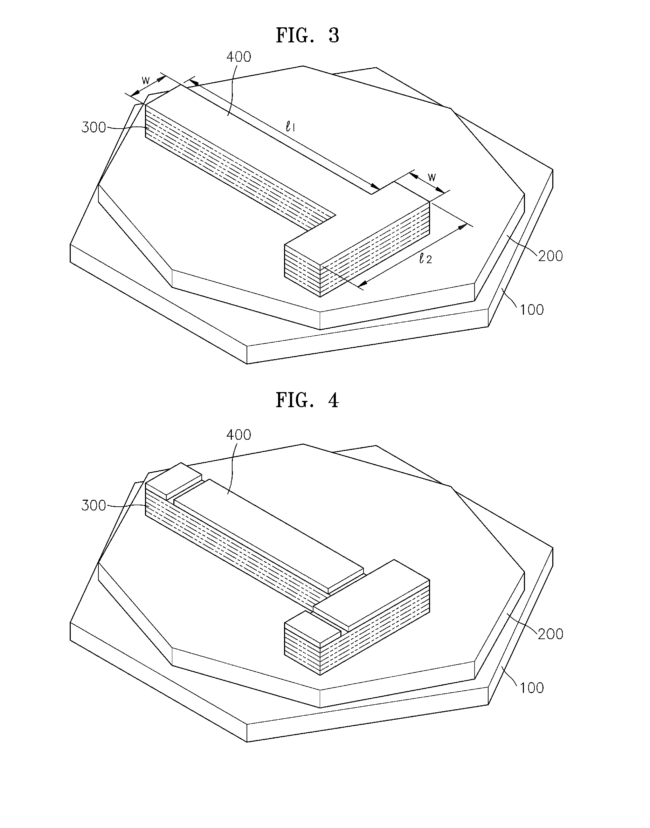

Figures 3 through 9 are schematics to explain a method of manufacturing a THz electromagnetic wave radiation and detection device by using a high-Tc superconducting material as described in relation to Figure 2. In Figures 3 through 9, the same reference numerals as in Figure 2 indicate the same elements as in Figure 2.

Figure 3 shows steps to fabricate a superconducting single crystal basal part 200, a superconducting single crystal mesa structure unit 300 (hereinafter referred to as a mesa structure 300) having a T shape, and the patterned first gold layer 400.

More specifically, a high-Tc superconducting single crystal, such as Bi₂Sr₂CaCu₂O_{8+X} or Tl₂Ba₂Ca₂Cu₃O_{10+X}, is prepared. In the highly anisotropic superconducting single crystal, intrinsic Josephson junctions are serially stacked. Then, the first substrate 100, e.g. a glass plate, a sapphire plate, or a magnesium oxide plate, is spin-coated with a negative photoresist or polyimide in the liquid state. The prepared superconducting single crystal is placed on the first substrate 100 coated with the negative photoresist or polyimide and is hard baked in an oven, so that the superconducting single crystal can be fixed in the first substrate 100.

After an adhesive tape or the like is attached to the top surface of the superconducting single crystal, the upper part of the superconducting single crystal is detached such that a freshly cleaved surface is prepared on top of the superconducting single crystal, where the first gold layer of 50 nm is deposited.

Next, a micropatterning process by using photolithography or electron-beam lithography and dry etching is applied to the first gold layer such that the first gold layer and the superconducting single crystal underneath are patterned to a specified depth. Then, the superconducting single crystal basal part 200, the mesa structure 300 having the T shape, and the patterned first gold layer 400 are formed on the first substrate 100.

The width *w* of the mesa structure 300 in the T shape is 1-5 micrometers, which is shorter than the Josephson penetration depth. The long side *l*₁ of the mesa structure 300 is 20-50 micrometers which is longer than the Josephson penetration depth. The length of the short side *l*₂ of the mesa structure 300 is 5-15 micrometers. The length of the short side *l*₂ and the width *w* are controlled such that the junction area of the electromagnetic wave detection unit B of Figure 2, i.e. *l*₂ x w, is larger than 1 µm².

The width *w* of the mesa structure 300 in the T shape ranges from approximately tens of nanometers (nm) to hundreds of nanometers. The height of the mesa structure 300 in the T shape is controlled by the etching time. The long side of the mesa structure 300 in the T shape is to be used as the electromagnetic wave generation unit A of Figure 2, and the short side of the mesa structure 300 in the T shape is to be used as the electromagnetic wave detection unit B of Figure 2.

Figure 4 shows a process of dividing the patterned first gold layer 400 into four parts. More specifically, in order to make it possible to use a four-probe method in the electromagnetic generation unit A of Figure 2 and the electromagnetic wave detection unit B of Figure 2, the patterned first gold layer 400 on the surface of the mesa structure 300 is divided into four parts using micropatterning, wet etching, or dry etching. The patterned first gold layer 400 is wet etched with the KI acid solution diluted with distilled water at a ratio of 1 to 1. The density of the solution can be controlled depending on the desired etching time. Etching of the patterned first gold layer 400 may be extended to a depth beyond the thickness of the patterned first gold layer 400 into the mesa structure 300.

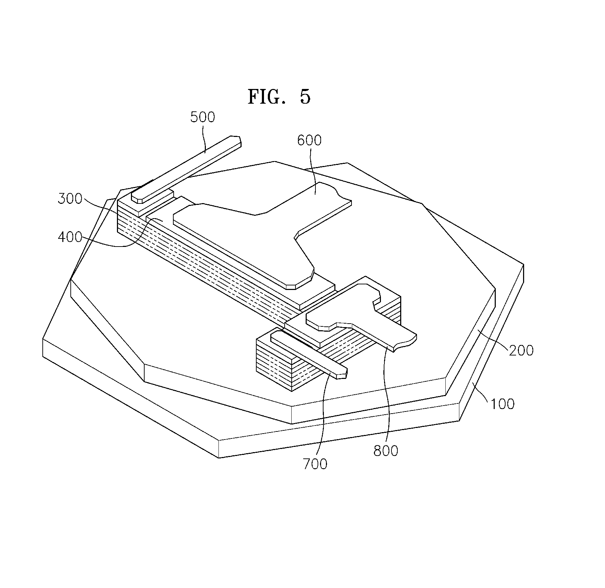

Figure 5 shows a process of forming the first voltage electrode 500, the first current electrode 600, the second voltage electrode 700, and the second current electrode 800. More specifically, the first voltage electrode 500, the first current electrode 600, the second voltage electrode 700, and the second current electrode 800 are formed on the patterned first gold layer 400, which is divided into four parts. The first voltage electrode 500 and the first current electrode 600 are formed in the electromagnetic wave generation unit A of Figure 2, and the second voltage electrode 700 and the second current electrode 800 are formed on the electromagnetic wave detection unit B of Figure 2. It is possible to connect operating units of the THz electromagnetic wave radiation and detection device to external measurement instruments using the first voltage electrode 500, the first current electrode 600, the second voltage electrode 700, and the second current electrode 800.

The first voltage electrode 500, the first current electrode 600, the second voltage electrode 700, and the second current electrode 800 are formed by applying micropatterning, wet etching, or dry etching to a noble metallic layer (such as Au) of 100-300nm. It is preferable that the size of the first current electrode 600 and the second current electrode 800 are maximized to make the tunnelling bias current flow along the c axis of the mesa 300 as uniform as possible, while the size of the first voltage electrode 500 and the second voltage electrode 700 are minimized as far as the micorpatterning process is possible.

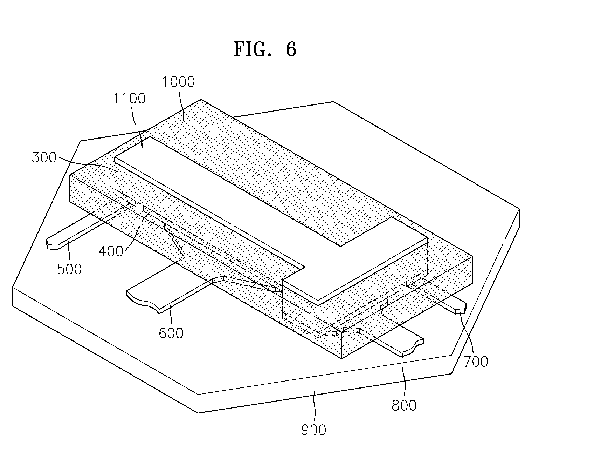

Figure 6 shows a process of turning over the first substrate 100, attaching the first substrate 100 to the second substrate 900, and detaching the first substrate 100 from the superconducting single crystal basal part 200.

More specifically, Figure 6 is a view for explaining the cleaving process to form electrodes on the opposite side of the mesa structure 300. Firstly, the second substrate 900 is spin-coated with negative photoresist or polyimide in the same manner as Figure 3. Then, the first substrate 100 is turned over, and the first voltage electrode 500, the first current electrode 600, the second voltage electrode 700, and the second current electrode 800 are placed on the second substrate 900 and are hard-baked to fix them to the second substrate 900.

Next, the first substrate 100 and the second substrate 900 are separated from each other by applying a force while the superconducting single crystal basal part 200 is detached along with the first substrate 100. Thus, the first voltage electrode 500, the first current electrode 600, the second voltage electrode 700, and the second current electrode 800 are fixed to the second substrate 900, while the opposite side of the mesa structure 300 are surfaced. In general, when the two substrates are detached, the superconducting single crystal basal part 200 may not be fully removed from the mesa structure 300. In this case, the cleaving process with a piece of adhesive tape may be repeated until the superconducting single crystal basal parts 200 are fully removed from the mesa structure 300. Undergoing this process, the surface of the photoresist or polyimide insulating interlayer1000, which is used to fix the first voltage electrode 500, the first current electrode 600, the second voltage electrode 700, and the second current electrode 800 to the second substrate 900, is formed at the same level as the newly formed surface of the mesa structure 300.

Then, a second gold layer with thickness of 100-300 nm is deposited on the newly formed surface of the mesa structure 300 and on the entire surface of the insulating interlayer 1000. The second gold layer is patterned subsequently to fit the underlying mesa structure 300 in the T shape as shown in Figure 6 using micropatterning, photolithography or electron-beam lithography, and wet etching or dry etching. Thus, the patterned second gold layer 1100 is formed on the newly formed surface of the mesa structure 300.

The insulating interlayer 1000 is patterned using micropatterning, photolithography or electron-beam lithography, and dry etching in such a manner as to expose the ends of the first voltage electrode 500, the first current electrode 600, the second voltage electrode 700, and the second current electrode 800.

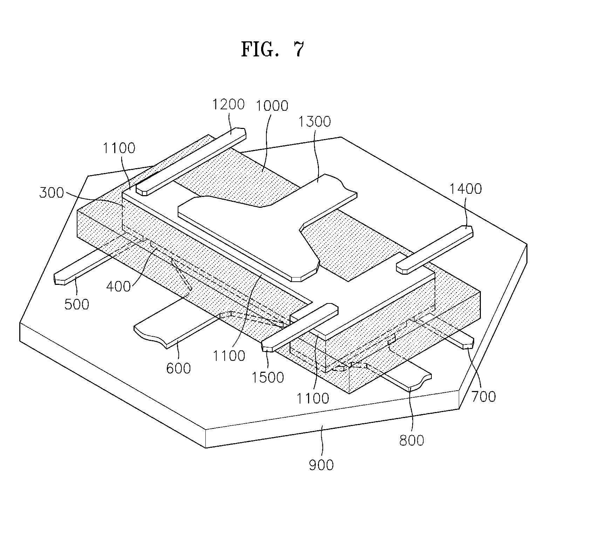

Figure 7 shows a process of forming the third voltage electrode 1200, the third current electrode 1300, the fourth voltage electrode 1400, and the fourth current electrode 1500.

More specifically, the third voltage electrode 1200, the third current electrode 1300, the fourth voltage electrode 1400, and the fourth current electrode 1500, which are electrically connected to the patterned second gold layer 1100, are formed. The third voltage electrode 1200 and the third current electrode 1300 are formed in the electromagnetic wave generation unit A. The fourth voltage electrode 1400 and the fourth current electrode 1500 are formed in the electromagnetic wave detection unit B. It is possible to connect operating units of the THz electromagnetic wave radiation and detection device to outside measurement instruments through the third voltage electrode 1200, the third current electrode 1300, the fourth voltage electrode 1400, and the fourth current electrode 1500.

The third voltage electrode 1200, the third current electrode 1300, the fourth voltage electrode 1400, and the fourth current electrode 1500, are formed by performing micropatterning, and wet etching or the dry etching on a noble metallic layer (such as Au) with the thickness of 100-300nm. It is preferable to maximize the size of the third current electrode 1300, while the size of the third voltage electrode 1200 is minimized as far as the micropatterning is possible, so that the tunnelling bias current becomes uniform in the mesa structure 300.

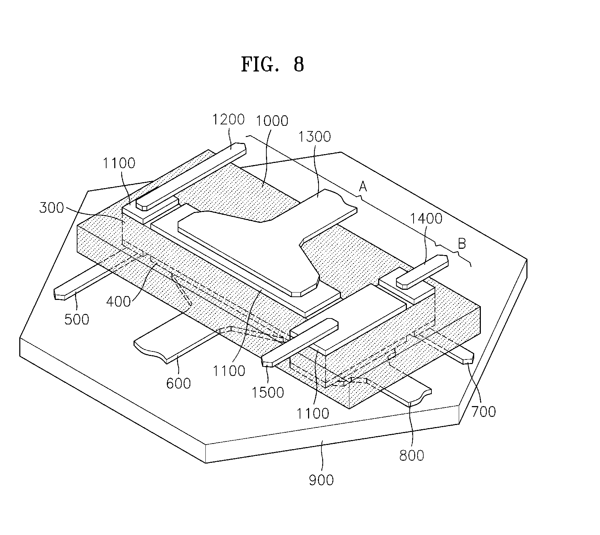

Figure 8 shows a process of dividing the patterned second gold layer 1100 into four parts.

More specifically, the patterned second gold layer 1100 is divided into four parts so as to make it possible to use the four-probe method in the same manner as in Figure 5. That is, the patterned second gold layer 1100 is divided into four parts to be used as the third voltage electrode 1200, the third current electrode 1300, the fourth voltage electrode 1400, and the fourth current electrode 1500. Etching the patterned second gold layer 1100 may be extended to a depth beyond the thickness of the patterned second gold layer 1100 into the mesa structure 300. As a result, electrodes for performing the four-probe measurements on tunnelling characteristics of the mesa 300 are formed on top and bottom of the mesa structure 300.

The process of dividing the patterned second gold layer 1100 into four parts in Figure 8 may be done prior to the process of forming the third voltage electrode 1200, the third current electrode 1300, the fourth voltage electrode 1400, and the fourth current electrode 1500 as in Figure 7.

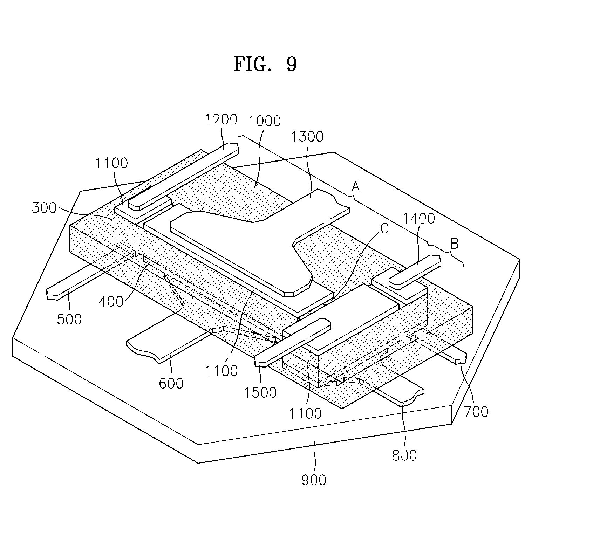

Figure 9 shows a process of forming the insulating unit C.

More specifically, in order to effectively utilize four-probe measurements configuration of intrinsic Josephson junctions on the mesa 300, the insulating unit C is formed. It separates the electromagnetic wave generation unit A in Figure 2 from the electromagnetic wave detection unit B in Figure 2 in the mesa structure 300 having the T shape. For that purpose, silicon ion implantation is performed in the mesa structure 300 between the third current electrode 1300 and the electromagnetic wave detection unit B as shown in Figure 9. That is, silicon ions are implanted into a portion where the second gold layer 1100 is divided by etching the second gold layer 1100 in the mesa structure 300 having the T shape. Thus, the insulating unit C is formed in the area between the short and long sides of the mesa structure 300 having the T shape and in the portion where the first gold layer 400 and the second gold layer 1100 are divided.

The silicon ions implanted into the mesa structure 300 of the second gold layer 1100 capture the oxygen atoms in the superconducting Cu₂O layer in the irradiated area, driving the Cu₂O layer to be highly underdoped. That is, the Cu₂O layer, which is conductive in the as-grown state, becomes insulating if the Cu₂O layer is highly underdoped by heavy silicon ion implantation. As a result, a portion between the electromagnetic wave generation unit A, i.e. the long side of the mesa structure 300 having the T shape, and the electromagnetic wave detection unit B, i.e. the short side of the mesa structure 300 having the T shape, is converted into the insulating unit C. Through a process of converting the Cu₂O layer into the insulating unit C using Si ion implantation, the electromagnetic wave generation unit A and the electromagnetic wave detection unit B are electrically insulated although they are mechanically connected. Thus, the plasma oscillation of superconducting electron pairs can be converted into radiation of a THz electromagnetic wave at the boundary between the electromagnetic wave generation unit A and the electromagnetic wave detection unit B without loss of reflection due to the intrinsic impedance mismatch. This method provides a means to extract the excited THz microwave to the environment out of the electromagnetic wave generation unit A and utilize it for varied purposes.

A THz electromagnetic wave radiation and detection device according to an embodiment of the present invention can excite a THz electromagnetic wave using Josephson fluxon motion in a superconducting single crystal mesa structure. It may also provide means to accurately detect and diagnose the excited THz electromagnetic wave.

In such a THz electromagnetic wave radiation and detection device, the phases of excited THz electromagnetic waves from stacked intrinsic Josephson junctions can be coherent with each other. Thus the output of the excited THz electromagnetic wave can be much enhanced over that from a single Josephson junction. The radiation excited from a preferred embodiment of this invention is continuous rather than pulse-like, so that it is useful for wider fields of applications. It is also possible to tune a frequency of the radiation from the THz electromagnetic wave radiation and detection device, by controlling the tunnelling bias current or the external magnetic field.

Recently, demands for THz electromagnetic waves have continuously increased in diverse fields such as medical diagnosis, radar modelling, moisture and chemical analysis, non-destructive examination of polymer material, telecommunications and so on. However, technology for generating electromagnetic waves in a THz range has not previously been established. Therefore, the THz electromagnetic wave radiation and detection device using the intrinsic Josephson junctions according to embodiments of the present invention can contribute significantly to bridging this technology gap.

While exemplary embodiments of the present invention have been particularly shown and described, it will be understood by those of ordinary skill in the art that various changes in form and details may be made therein without departing from the spirit and scope of the present invention as defined by the following claims and their equivalents.

In this specification, the verb "comprise" has its normal dictionary meaning, to denote non-exclusive inclusion. That is, use of the word "comprise" (or any of its derivatives) to include one feature or more, does not exclude the possibility of also including further features.

In this specification, terms of absolute orientation are used conveniently to denote the usual orientation of items in normal use and/or as shown in the accompanying drawings. However, such items could be disposed in other orientations, and in the context of this specification, terms of absolute orientation, such as "top", "bottom", "left", "right", "vertical" or "horizontal", etc. are to be construed accordingly, to include such alternative orientations.

The reader's attention is directed to all and any priority documents identified in connection with this application and to all and any papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A THz electromagnetic wave radiation and detection device comprising:
an electromagnetic wave generation unit (A) which is formed of a superconducting single crystal mesa structure (300) in which intrinsic Josephson junctions (6) of superconducting layers (2) and insulating layers (4) are serially stacked and which can excite a THz electromagnetic wave;
an insulating unit (B) which contacts the electromagnetic wave generation unit (A) and is not conductive; and
an electromagnetic wave detection unit (C) which contacts the insulating unit (B), is formed of the superconducting single crystal mesa structure (300) in which intrinsic Josephson junctions (6) of the superconducting layers (2) and the insulating layers (4) are serially stacked, and can detect the THz electromagnetic wave.

2. A device according to claim 1, wherein the electromagnetic wave generation unit (A) and the insulating unit (B) correspond to a long side of the superconducting single crystal mesa structure (300), which has a T shape, and the electromagnetic wave detection unit (C) corresponds to a short side of the superconducting single crystal mesa structure (300) having the T shape.

3. A device according to claim 2, wherein the length of the long side of the superconducting single crystal mesa structure (300) having the T shape included in the electromagnetic wave generation unit (A) is longer than the Josephson penetration depth, and the length of the short side of the superconducting single crystal mesa structure (300) having the T shape included in the electromagnetic wave detection unit (C) is shorter than the Josephson penetration depth.

4. A THz electromagnetic wave radiation and detection device comprising:
a first mesa structure unit (A) which is formed of a superconducting single crystal mesa structure (300) wherein intrinsic Josephson junctions (6) of superconducting layers (2) and insulating layers (4) are serially stacked;
an insulating unit (B) which contacts the first mesa structure unit (A); and
a second mesa structure unit (C) which is formed of the superconducting single crystal mesa structure (300) wherein intrinsic Josephson junctions (6) of superconducting layers (2) and insulating layers (4) are serially stacked.

5. A device according to claim 4, wherein the first mesa structure unit (A) and the insulating unit (B) correspond to a long side of the superconducting single crystal mesa structure (300), and the second mesa structure unit (C) corresponds to a short side of the superconducting single crystal mesa structure (300).

6. A device according to claim 5, wherein the length of the long side of the superconducting single crystal mesa structure (300), which has a T shape, included in the first mesa structure unit (A) is longer than a Josephson penetration depth, and the length of the short side of the superconducting single crystal mesa structure (300) having the T-shape included in the second mesa structure unit (C) is shorter than the Josephson penetration depth.

7. A THz electromagnetic wave radiation and detection device comprising:
a first mesa structure unit (A) which is formed of a superconducting single crystal mesa structure (300) wherein intrinsic Josephson junctions (6) of superconducting layers (2) and insulating layers (4) are serially stacked;
an insulating unit (B) which contacts the first mesa structure unit (A) and is not conductive; and
a second mesa structure unit (C) which is formed of the superconducting single crystal mesa structure (300) where intrinsic Josephson junctions (6) of superconducting layers (2) and insulating layers (4) are serially stacked:
wherein Josephson fluxons (12) are formed in insulating layers (4) of the Josephson junctions (6) by applying an external magnetic field to the intrinsic Josephson junctions (6) in parallel in the first mesa structure unit (A); plasma radiation by the Josephson fluxon motion is maintained by flowing a tunnelling bias current along the c axis of the superconducting single crystal mesa structure (300) included in the first mesa structure unit (A); the plasma oscillation is converted into radiation of a THz electromagnetic wave while passing through the insulating unit (B); and the radiation frequency of the THz electromagnetic wave transmitted to the second mesa structure unit (C) contacting the insulating unit (B) is detected.

8. A device according to claim 7, wherein the radiation of the THz electromagnetic wave transmitted to the second mesa structure unit (C) generates current steps known as Shapiro steps at voltages corresponding to the radiation frequency f due to an inverse Josephson effect, i.e. V=hf/2e (here, h denotes the Planck constant, and e denotes the charge of electrons), and the radiation frequency of the THz electromagnetic wave is detected by using the current steps.

9. A THz electromagnetic wave radiation and detection device comprising:
a superconducting single crystal which is attached to a substrate (100) and forms a superconducting single crystal mesa structure (300) having a T shape and in which intrinsic Josephson junctions (6) of superconducting layers (2) and insulating layers (4) are serially stacked;
a first gold layer (400) which is divided into four parts on the bottom surface of the superconducting single crystal mesa structure (300) having the T-shape;
a first voltage electrode (500), a first current electrode (600), a second voltage electrode (700) and a second current electrode (800) which are formed on the divided four parts of the first gold layer (400);
a second gold layer (1100) which is divided into four parts on the top surface of the superconducting single crystal mesa structure (300) having the T shape;
a third voltage electrode (1200), a third current electrode (1300), a fourth voltage electrode (1400) and a fourth current electrode (1500) which are formed on the divided four parts of the second gold layer (1100);
an insulating unit (B) which is formed in the stack between the long and the short sides of the superconducting single crystal mesa structure (300) having the T shape and in a portion where the first and second gold layers (400, 1100) are divided; and
an insulating interlayer which is formed on a substrate so as to partially expose the first voltage electrode (500), the first current electrode (600), the second voltage electrode (700), the second current electrode (800), and fully expose the third voltage electrode (1200), the third current electrode (1300), the fourth voltage electrode (1400), and the fourth current electrode (1500):
wherein the long side of the superconducting single crystal mesa structure (300) having the T shape forms an electromagnetic wave generation unit (A) where the THz electromagnetic wave is excited, and the short side of the superconducting single crystal mesa structure (300) having the T shape forms a electromagnetic wave detection unit (C) where the THz electromagnetic wave is diagnosed.

10. A method of manufacturing a THz electromagnetic wave radiation and detection device, the method comprising:
fixing a superconducting single crystal mesa structure (300), in which intrinsic Josephson junctions (6) of superconducting layers (2) and insulating layers (4) are serially stacked, to a first substrate (100);
forming a first gold layer (400) on a surface of a superconducting single crystal mesa structure (300);
forming a superconducting mesa structure (300) on the first substrate (100) by patterning the first gold layer (400) and the superconducting single crystal underneath;
dividing the first gold layer (400) into two parts respectively for short and long sides of the superconducting single crystal mesa structure (300) having a T shape;
forming a first voltage electrode (500) and a first current electrode (600), a second voltage electrode (700) and a second current electrode (800) on the long and short sides of the first gold layer (400), respectively;
turning over the first substrate (100) and fixing the first voltage electrode (500), the first current electrode (600), the second voltage electrode (700), and the second current electrode (800) to a second substrate (900);
detaching the superconducting single crystal basal part (200) along with the first substrate (100) so as to expose the opposite side of the superconducting single crystal mesa structure (300);
forming an insulating interlayer on the second substrate (900) so as to partially expose the first voltage electrode (500), the first current electrode (600), the second voltage electrode (700), and the second current electrode (800);
depositing a second gold layer (1100) on the newly exposed surface of the superconducting single crystal mesa structure (300);
dividing the second gold layer (1100) into two parts respectively for short and long sides of the superconducting single crystal mesa structure (300) having the T shape;
forming a third voltage electrode (1200) and a third current electrode (1300), a fourth voltage electrode (1400) and a fourth current electrode (1500) on the long and short sides of the second gold layer (1100), respectively; and
forming an insulating unit (B) in the junction area of short and long sides of the T-shaped superconducting single crystal mesa structure (300) and in the area where the first gold layer (400) and the second gold layer (1100) are respectively divided:
wherein the long side of the T-shaped superconducting single crystal mesa structure (300) constitutes an electromagnetic wave generation unit (A), and the short side of the T-shaped superconducting single crystal mesa structure (300) constitutes an electromagnetic wave detection unit (C).

11. A method according to claim 10, wherein the insulating unit (B) is formed by performing silicon ion implantation to the stack of short and long sides of the superconducting single crystal mesa structure (300) having the T shape and in an area where the first gold layer (400) and the second gold layer (1100) are divided.

12. A method according to claim 10 or 11, wherein fixing the superconducting single crystal mesa structure (300) to the first substrate (100) comprises:
spin-coating the first substrate (100) with photoresist or polyimide in its liquid state; and
placing the superconducting single crystal on the first substrate (100) coated with photoresist or polyimide and hard-baking the superconducting single crystal mesa structure (300).

13. A method according to claim 10, 11 or 12, wherein the superconducting single crystal mesa structure (300), the superconducting single crystal basal part (200), and the patterned first gold layer (400) are formed using micropatterning and dry etching.

14. A method according to any of claims 10 to 14, wherein a height of the superconducting single crystal mesa structure (300) is controlled by etching time.

15. A device or method according to any of the preceding claims, wherein the superconducting mesa structure (300) comprises a high-Tc superconducting single crystal.

16. A device or method according to claim 15, wherein the high-Tc superconducting single crystal comprises Bi₂Sr₂CaCu₂O_{8+X} or Tl₂Ba₂Ca₂Cu₃O_{10+X}.
